(19) Europäisches Patentamt
European Patent Office
Office européen des brevets

(11) EP 2 552 021 A1

(12) EUROPEAN PATENT APPLICATION

(43) Date of publication:
**30.01.2013 Bulletin 2013/05**

(51) Int Cl.:
***H03K 17/22*** *(2006.01)*

(21) Application number: **11175627.6**

(22) Date of filing: **27.07.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **austriamicrosystems AG**
**8141 Unterpremstätten (AT)**

(72) Inventors:
- **Colombo, Matteo**
  **27040 Verrua Po (Pavia) (IT)**
- **Draghi, Paolo**
  **27100 Pavia (IT)**

(74) Representative: **Epping - Hermann - Fischer Patentanwaltsgesellschaft mbH**
**Ridlerstraße 55**
**80339 München (DE)**

# (54) Voltage detection arrangement

(57) A voltage detection arrangement comprises a series connection (1) of a resistive voltage divider (2) and a controlled section of a field effect transistor (MR). The series connection (1) is coupled between a first supply potential terminal (VDD) and a second supply potential terminal (VSS). The voltage divider (2) comprises a first resistor (11) and a second resistor (12) being serially connected, a connection point (13) of the first resistor (11) and the second resistor (12) being connected to a gate connection (5) of the field effect transistor (MR). A comparator (3) is at its input side connected to a connection point (4) of the field effect transistor (MR) and the voltage divider (2), and on its output side coupled to a detection output (6) of the voltage detection arrangement.

Fig 1

VDD
1
5
S
MR
3
D
POR
4
6
Ra
11
13
2
Rb
12
VSS

EP 2 552 021 A1

## Description

The invention relates to a voltage detection arrangement which, for example, may be used in a power-on reset, POR, circuit.

In many electrical circuits, power-on reset, POR, circuits are used in order to detect a minimum supply voltage that is able to fulfill dynamic range requirements of the electrical circuit.

Some conventional POR circuits comprise a field-effect transistor that switches, if a desired supply voltage at a supply terminal is reached after powering on the electrical circuit. To this end, the transistor may be designed with a specific width-to-length, W/L, ratio for setting a desired switching level.

If the same implementation of a power-on reset circuit is to be used in different electrical circuits having different minimum supply voltage requirements, it is desirable to adapt the desired switching level of the transistor. However, this may result in a change of geometry of the transistor or the provision of additional circuit parts for the POR circuit. In conventional POR circuits, such additional circuit parts may have the effect that the switching level has a temperature dependency such that the supply voltage requirements may not be fulfilled for all temperatures.

It is an object of the invention to provide an improved concept for a voltage detection arrangement allowing an adaptation of a switching level and having a reduced temperature dependency.

This object is achieved with the subject matter of the independent claim. Embodiments and developments of the invention are the subject matter of the dependent claims.

According to various embodiments of a voltage detection arrangement, a series connection of a resistive voltage divider and a controlled section of a field-effect transistor is provided between a first and a second supply potential terminal. A connection point between the field-effect transistor and the voltage divider is connected to a comparator for providing a stable, logic output level. A threshold level for a switching of the voltage detection arrangement can be set by means of the ratio of the voltage divider. Furthermore, the field-effect transistor can be operated such that at the switching level, a thermally independent operation point is set. Hence, the voltage detection arrangement is adaptable to various switching levels while at the same time a reasonable temperature dependency can be accomplished.

According to one embodiment of the voltage detection arrangement, the series connection of the resistive voltage divider and the control section of the field-effect transistor is coupled between the first supply potential terminal and the second supply potential terminal. The voltage divider comprises a first resistor and a second resistor being serially connected, wherein a connection point of the first resistor and the second resistor is connected to a gate connection of the field-effect transistor. The comparator is connected to a connection point of the field-effect transistor and the voltage divider at its input side, and is coupled to a detection output of the voltage detection arrangement at its output side. For example, the first resistor has one end connected to the control section of the field-effect transistor and the other end connected to the second resistor.

Preferably, the source connection of the field-effect transistor is coupled to the first supply potential terminal and the drain connection is connected to the voltage divider. The field-effect transistor may be an n-channel field-effect transistor having its source connection connected to a lower supply potential, or be a p-channel field-effect transistor having its source connection connected to a higher supply potential.

If a supply voltage between the first and the second supply potential terminal rises and, in particular, reaches a threshold voltage of the transistor, the transistor switches to a conducting state. The supply voltage drops over the controlled section and the voltage divider, wherein the voltage drop across the controlled section may be negligible compared to the voltage drop across the voltage divider. Accordingly, the supply voltage basically drops across the voltage divider. As a consequence, a threshold level for switching or a switching level, respectively, is determined by the voltage drop across the second resistor in conjunction with the gate-source-voltage of the transistor. Furthermore, the gate-source-voltage of the transistor corresponds to the voltage drop across the first resistor. Hence, by dimensioning of the first resistor, an operation point of the transistor can be set.

A thermal dependency of the field-effect transistor results from a thermal dependency of a threshold voltage of the transistor and an overdrive voltage resulting from a difference of the gate-source-voltage and the threshold voltage of the transistor. The threshold voltage of the transistor usually has a negative temperature coefficient, while the overdrive voltage has a positive temperature coefficient. For a specific combination of the threshold voltage and the overdrive voltage, resulting in a specific gate-source-voltage and a specific drain-current, positive and negative temperature effects compensate each other. At this combination, the field-effect transistor is operated at a thermal compensation point having zero or little temperature dependency.

Accordingly, in various embodiments, the first resistor, which is connected between one terminal of the controlled section of the field-effect transistor and the gate connection of the field-effect transistor, is dimensioned such that the field-effect transistor is operated at or basically at the thermal compensation point regarding a temperature dependency of a drain-current and a gate-source-voltage of the field-effect transistor. In particular, the voltage drop across the first resistor corresponds to the gate-source-voltage, and the current through the first resistor corresponds to the drain-current. Due to production tolerances of the resistors and the transistor, the thermal compensation point may not be achieved exactly but with slight deviations. However, the transistor is still operated basically at the thermal compensation point in this case.

According to one embodiment, the voltage divider comprises a resistor array of a plurality of serially connected resistors, which form the first resistor and the second resistor. For example, a tap between two of the plurality of serially connected resistors forms the connection point of the first resistor and the second resistor. Hence, the resistor array may be seen as one resistor which is divided into the first resistor and the second resistor by the tap which is connected to the gate connection of the transistor.

The resistor array may comprise a plurality of taps between each two of the plurality of serially connected resistors. One of the plurality of taps may be fixed at the connection point of the first resistor and the second resistor on the basis of a desired threshold level. Hence, the same voltage detection arrangement can be used for different electrical circuits having different desired threshold levels. In particular, the threshold level indicates the supply voltage, which has to be reached or exceeded between the first and the second supply potential terminal in order to indicate a sufficient voltage supply for e.g. a respective electrical circuit.

According to a further embodiment, the first resistor and the second resistor are formed by a resistor strip, wherein a tap on the resistor strip forms the connection point of the first resistor and the second resistor. For example, the resistor strip may be implemented as a semiconductor-based resistor in an integrated circuit. The resistor strip may be provided with several taps, such that one of these taps is selected as the connection point to be connected to the gate connection of the field-effect transistor. The resistor strip having several taps may form a resistor array according to one of the embodiments described above.

According to a further embodiment, the series connection of the resistive voltage divider and the field-effect transistor is coupled to the first supply potential terminal or to the second supply potential terminal by means of a parallel connection of a third resistor and a switch. During operation of the voltage detection arrangement, a current through the series connection will further effect a voltage drop across the third resistor. Accordingly, the threshold level is shifted on the basis of this additional voltage drop. Accordingly, the threshold level with the third resistor being applied is higher than without the third resistor. The third resistor can be bridged by the switch, such that the threshold level can be set to one of two different threshold levels. A threshold hysteresis can be achieved in this way.

For example, the switch is controlled on the basis of a signal at the detection output. In particular, the switch may be controlled to an open state in a startup phase before the respective threshold level is reached, resulting in a higher startup threshold level. If the voltage detection arrangement changes its output state at the detection output, the switch can be controlled to a closed state such that a lower threshold level results. Hence, if the supply voltage between the first and the second supply potential terminal once exceeds the higher threshold level, the lower threshold level is set by means of the switch, such that small variations of the supply voltage around the first threshold level do not force the voltage detection arrangement to switch back to its output state. As a consequence, due to the hysteresis a more stable behavior of the signal at the detection output can be achieved.

According to further embodiments, the series connection is coupled to the first supply potential terminal or to the second supply potential terminal by means of one or more serially connected calibration resistors. Each of the calibration resistors is bridgeable or bridged by a calibration switch. Similar to the effects described in conjunction with the third resistor, also the calibration resistors are able to increase the threshold level of the voltage detection arrangement. Hence, production tolerances, for example, or other deviations of, in particular, the second resistor can be compensated by enabling one or more of the calibration resistors in order to achieve a desired threshold level. The calibration resistors, which are not to be enabled, can be bridged by the respective calibration switches.

For example, the threshold level of the voltage detection arrangement can be tested in a calibration process. As a result, it can be determined in the calibration process which of the calibration resistors should be enabled and which should be disabled. Accordingly, a conduction state of each of the calibration switches may be programmed in a calibration process.

In various embodiments, at least one calibration switch is implemented as a fuse, for example a laser fuse or a polyfuse. Such fuses can be blown, for example, in a calibration process.

In a further embodiment, the comparator is implemented as an inverter, in particular a CMOS inverter. Such CMOS inverter may have the series connection of an n-channel field-effect transistor and a p-channel field-effect transistor. A comparator level is given by the threshold voltages of the transistors of the CMOS inverter.

According to a further embodiment, the comparator is implemented as a differential amplifier. A first input of the differential amplifier is connected to the connection point of the field-effect transistor and the voltage divider, and a second input of the differential amplifier is coupled to a reference voltage terminal. For example, a reference voltage, which should be exceeded during detection, can be provided at the reference voltage terminal.

The voltage detection arrangement according to one of the embodiments described above, may be used as a POR circuit in an electrical circuit.

The text below explains the invention in detail using exemplary embodiments with reference to the drawings. Same reference numerals are used for same elements or elements having a similar function in the various figures. In the drawings:

FIG. 1 shows an embodiment of a voltage detection arrangement,

FIG. 2 shows a further embodiment of a voltage detection arrangement,

FIG. 3 shows a further embodiment of a voltage detection arrangement,

FIG. 4 shows a further embodiment of a voltage detection arrangement,

FIG. 5 shows a further embodiment of a voltage detection arrangement, and

Fig. 6 shows a further embodiment of a voltage detection arrangement.

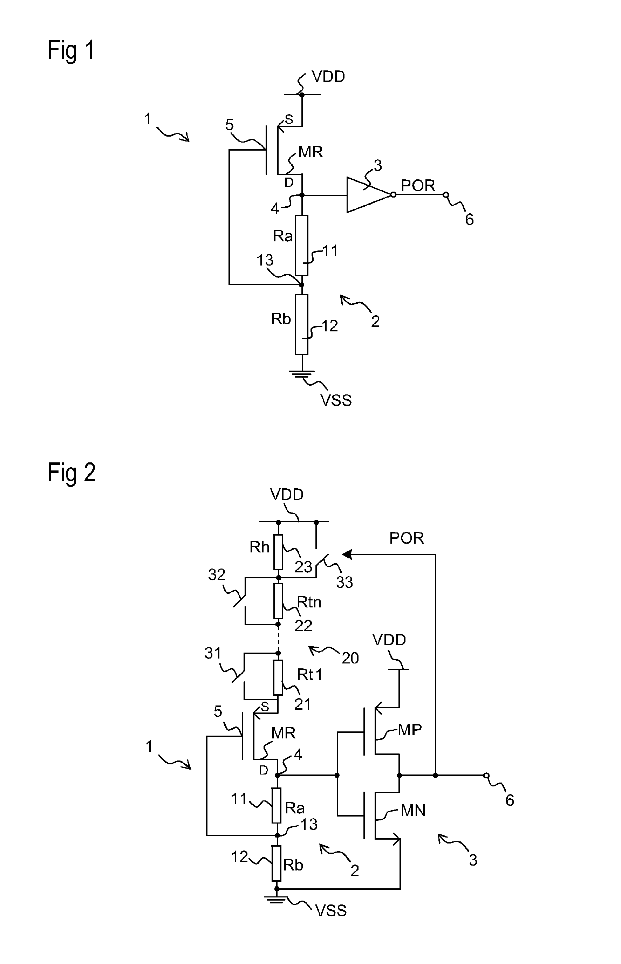

FIG. 1 shows an embodiment of a voltage detection arrangement which comprises a series connection 1 of a field-effect transistor MR and a voltage divider 2. A connection point 4 of the transistor MR and the voltage divider 2 is connected to a comparator 3, which is implemented as an inverter in this case. An output of the comparator 3 or inverter, respectively, is connected to a detection output 6. The series connection 1 is coupled between a first supply potential terminal VDD and a second supply potential terminal VSS. The voltage divider 2 comprises a first resistor 11 and a second resistor 12, wherein a connection point 13 of the resistors 11, 12 is connected to a gate connection 5 of the transistor MR.

During operation of the voltage detection arrangement, it is assumed that a supply voltage between the first and the second supply potential terminals VDD, VSS is applied and rises from a zero value to a final supply voltage value. If a certain threshold level of the supply voltage is reached or exceeded, the voltage detection circuit provides a respective logic signal POR at the detection output 6. In general, as soon as the supply voltage is a few mV above the threshold voltage, the gain of the transistor MR makes the voltage drop across the voltage divider 2 equal or approximately equal to the supply voltage. In this way, the connection point 13 between the resistors 11, 12 sustains a voltage, which is proportional to the supply voltage.

It is desirable that the transistor MR, which is implemented as a PMOS transistor in this embodiment, is operated at an operating point thermally stable for a desired threshold level. To this end, temperature effects of the resistor MR may be considered. In particular, a gate-source-voltage $V_{GS}$ of the transistor MR depends on a threshold voltage $V_{th}$ and an overdrive voltage $V_{overdrive}$ according to

$$V_{GS} = V_{th} + (V_{GS} - V_{th}) = V_{th} + V_{overdrive} . \quad (1)$$

The threshold voltage $V_{th}$ has a negative temperature coefficient, NTC, while the overdrive $V_{overdrive}$ has a positive temperature coefficient, PTC. At a certain combination of $V_{th}$ and $V_{overdrive}$, the transistor MR can be operated at a thermal compensation point, where temperature effects compensate each other and, therefore, are negligible. This specific combination of $V_{th}$ and $V_{overdrive}$ results in a specific drain-current $I_D$ of the transistor MR. Accordingly, a voltage drop $V_{Ra}$ across the resistor 11 having the resistance Ra results to

$$V_{Ra} = I_D \cdot Ra . \quad (2)$$

Assuming that the threshold voltage $V_{th}$ is negligible due to a low resistance of the controlled section of the transistor MR, it can be assumed that

$$V_{Ra} \approx V_{GS} \quad (3)$$

Hence, the resistance Ra for the thermal compensation point can be dimensioned according to

$$Ra = \frac{V_{GS}}{I_D} \qquad (4)$$

with the above-mentioned specific values for $V_{GS}$ and $I_D$. In particular, the transistor MR can be operated at the thermal compensation point regardless of a resistance Rb of the second resistor 12.

Regarding the desired threshold level $V_{DD,trip}$, at which the voltage detection arrangement should switch, if reached or exceeded between the supply potential terminals VDD, VSS, it can be assumed in particular with respect to equation (3) that

$$V_{DD,trip} = V_{GS} + V_{Rb} \approx V_{Ra} + V_{Rb}\,, \qquad (5)$$

wherein a voltage drop $V_{RB}$ across the second resistor 12 results to

$$V_{Rb} = Rb \cdot I_D\,. \qquad (6)$$

A combination of equations (3), (4) and (5) results to

$$V_{DD,trip} = V_{GS}\left(1 + \frac{Rb}{Ra}\right). \qquad (7)$$

In further considerations, an inverter threshold VDD/K, that is the voltage at which an output of the inverter 3 changes its state, can be taken into account to have a low or negligible temperature dependency of the inverter 3. Hence, the voltage drop across the resistors 11, 12 is equal to the inverter threshold VDD/K at the threshold level. With reference to the above explanations, the threshold level $V_{DD,trip}$ may then be calculated from the following formula:

$$V_{DD,trip} = V_{GS} + \left(\frac{Rb}{Ra+Rb}\right) \cdot \frac{V_{DD}}{K} \qquad (8)$$

In consequence, with respective dimensioning of resistances Ra, Rb of resistors 11, 12, the voltage detection arrangement can be operated with little or no temperature dependency, while at the same time, a desired threshold level $V_{DD,trip}$ can be set arbitrarily without affecting the good temperature behavior.

FIG. 2 shows a further embodiment of a voltage detection arrangement, which is based on the embodiment shown in FIG. 1. However, in addition to the embodiment described for FIG. 1, the series connection 1 is coupled to the first supply potential terminal VDD by means of a resistor array 20 comprising a plurality of serially connected calibration resistors 21, 22. For reasons of a better overview, only two resistors are shown in the drawing, while in various embodiments, there may be more than two, for example, n calibration resistors present. Furthermore, a third resistor 23 is connected in series to the resistor array 20 and the series connection 1.

Each of the calibration resistors 21, 22 has a parallel connected switch 31, 32 by which the calibration resistor can be bridged and therefore disabled. In a similar fashion, a switch 23 is connected in parallel to the third resistor 23, wherein a switch 33 is controlled by the signal POR at the detection output 6.

The inverter 3 is implemented as a CMOS inverter in this embodiment, wherein a series connection of a p-channel field-effect transistor MP and an n-channel field-effect transistor MN is included in the inverter 3.

The calibration resistors 21, 22 and the third resistor 23 have an effect on the threshold level of the voltage detection circuit, which will be explained in more detail separately for the calibration resistors 21, 22 and the third resistor 23.

The switches 31, 32 may be fuses, for example polyfuses or laser fuses, wherein a conduction state of the fuses may be programmed during a calibration process. Resistances Rt1, Rtn of the plurality of calibration resistors 21, 22 may be equal or have different values. For example, resistances Rt1, Rtn may be binary weighted. In the calibration process, some of the calibration resistors may be bridged and disabled and some calibration resistors may be enabled by not being bridged. In consequence, a total calibration resistance Rt results as the sum of the resistances of the enabled calibration resistors.

During operation of the voltage detection arrangement, a voltage drop $V_{Rt}$ results across the resistor array 20, which depends on the drain current and the calibration resistance Rt. The threshold level $V_{DD,trip}$ accordingly results to, similar to equation (5)

$$V_{DD,trip} = V_{GS} + V_{Rb} + V_{Rt}, \qquad (9)$$

which can be re-written as

$$V_{DD,trip} = V_{GS}\left(1 + \frac{Rb + Rt}{Ra}\right). \qquad (10)$$

By means of the calibration resistors, a mismatch of resistance Rb of the second resistor 12 due to production tolerances can be compensated. For example, fuses parallel to the calibration resistors 21, 22 may be blown in a calibration process in order to set or achieve a desired threshold level $V_{DD,trip}$. The voltage drop $V_{Rt}$ across the compensation resistor array 20 accordingly shifts the threshold level set by the first and the second resistor 11, 12. As the voltage shift or voltage drop $V_{Rt}$ depends on the temperature independent drain current $I_D$, temperature stability of the voltage detection arrangement is not affected.

In a similar fashion, a voltage drop $V_{Rh}$ across the third resistor 23 depends on the drain current $I_D$ and the resistance Rh of the third resistor 23. Neglecting the effects of the compensation resistors 21, 22 for ease of explanation, the threshold level $V_{DD,trip,h}$ with enabled third resistor 23 results to

$$V_{DD,trip,h} = V_{GS} + V_{Rb} + V_{Rh}, \qquad (11)$$

or, similar to equation (10), to

$$V_{DD,trip,h} = V_{GS}\left(1 + \frac{Rb + Rh}{Ra}\right). \qquad (12)$$

Hence, the voltage drop $V_{Rh}$ increases the threshold level compared to the threshold level defined in equation (7) without resistor 23 being enabled. This can be used to implement a hysteresis for the voltage detection circuit, such that a higher threshold level according to equation (12) is necessary to change the output stage POR at the detection output 6 as long as the supply voltage is below this higher threshold level. If the higher threshold level according to equation (12) is reached or exceeded, the output state POR changes, thus closing the switch 33 and disabling the third resistor 23. Accordingly, the threshold level changes to a level according to equation (7) or (10), respectively. Hence, small variations in the supply voltage, which are smaller than the previous voltage drop $V_{Rh}$, do not lead to a situation, where the output state POR changes back. Only if the supply voltage falls below the lower threshold level according to equation (7), the voltage detection arrangement is signaling an insufficient supply voltage by changing back the output state POR. Accordingly, a hysteresis can be achieved by means of the switchable resistor 23.

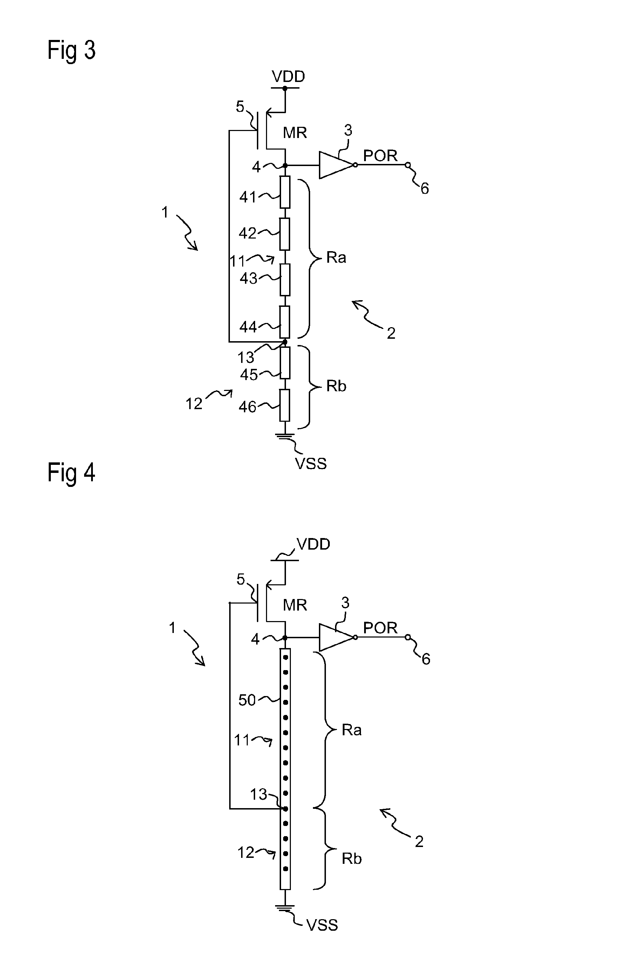

FIG. 3 shows a further embodiment of a voltage detection arrangement, which is based on the embodiment of FIG. 1. In this embodiment, the first resistor 11 and the second resistor 12 are formed by a resistor array comprising resistors 41, 42, 43, 44, 45, 46. In particular, the resistors 41, 42, 43, 44 form the first resistor 11, while the resistors 45, 46 form the second resistor 12. A tap may be present between each two resistors of the resistor array 41 - 46 which can be used for voltage division. In this particular embodiment, a tap between the resistors 44 and 45 forms the connection point 13 of the first and the second resistor 11, 12. However, a tap between two other resistors can be chosen as the connection point 13 in order to achieve a different voltage division ratio and different resistances Ra, Rb. The function of the voltage detection arrangement of FIG. 3 is similar or identical, as described for the embodiment of FIG. 1.

FIG. 4 shows another embodiment of a voltage detection arrangement, which is based on the embodiment of FIG. 1. In this embodiment, the first and the second resistor 11, 12 are implemented by a resistor strip 50, which has several taps on it for dividing the resistor strip 50. Similar to the embodiment shown in FIG. 3, one of the taps is chosen as the connection point 13 between the first and the second resistor 11, 12, thus determining the resistances Ra, Rb. The resistor strip 50 may be implemented in an integrated circuit, for example.

A calibration resistor array 20 and the third resistor 23 are arranged between the source connection of the transistor MR and the first supply potential terminal VDD in this embodiment. However, in various embodiments, at least one of the third resistor 23 and the compensation resistor array 20 may be arranged between the second resistor 12 and the second supply potential terminal VSS, without affecting the function of the voltage detection arrangement.

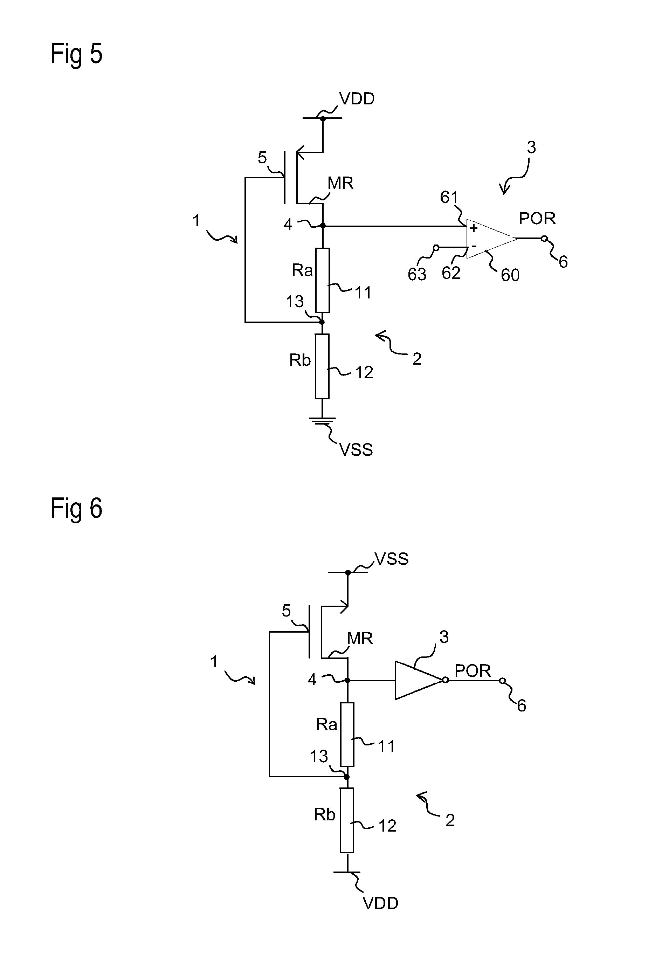

FIG. 5 shows a further embodiment of a voltage detection arrangement, wherein the comparator 3 is implemented as a differential amplifier 60 having a first input 61 connected to the connection point 4 between the transistor MR and the voltage divider 2, and a second input 62 connected to a reference voltage terminal 63. During operation of the voltage detection arrangement, a reference voltage is provided at the reference voltage terminal 63, for example by an external circuit.

In the embodiments described above for FIGs. 1 to 5, the transistor MR is implemented as p-channel field-effect transistor, e.g. a PMOS transistor. However, the p-channel field-effect transistor can also be replaced by an n-channel field-effect transistor, e.g. an NMOS transistor, in various embodiments.

FIG. 6 shows an embodiment of a voltage detection arrangement, which uses an NMOS transistor instead. A source connection of the transistor MR is connected to the second supply potential terminal VSS, while the voltage divider 2 is coupled to the first supply potential terminal VDD. Regarding its function, the voltage detection arrangement of FIG. 6 is similar to the embodiments described above.

In the various embodiments described above, the supply voltage to be detected preferably is a positive voltage from the first supply potential terminal VDD to the second supply potential terminal VSS.

The embodiments described above can be combined in various ways. In particular, the implementations shown in FIG. 3 to FIG. 6 can be combined with the embodiment shown in FIG. 2.

In all of the above described embodiments, a negligible temperature dependency can be achieved while making a variable adaptation of a threshold level possible. To this end, the transistor is operated at an operating point which is thermally stable, a thermal compensation point.

Reference list

| | |
|---|---|
| 1 | series connection |
| 2 | voltage divider |
| 3 | comparator |
| 4 | connection point |
| 5 | gate connection |
| 6 | detection output |
| 11, 12 | resistor |

| | |
|---|---|
| 13 | connection point |
| 20 | compensation resistor array |
| 21, 22 | compensation resistor |
| 23 | resistor |
| 31, 32, 33 | switch |
| 41, 42, 43 | resistor |
| 44, 45, 46 | resistor |
| 50 | resistor strip |
| 60 | differential amplifier |
| 61, 62 | input |
| 63 | reference voltage terminal |
| VDD, VSS | supply potential terminal |
| MR | transistor |
| POR | output state |
| Ra, Rb, Rh | resistance |
| Rt1, Rtn | resistance |
| MP, MN | transistor |

## Claims

**1.** Voltage detection arrangement, comprising

- a series connection (1) of a resistive voltage divider (2) and a controlled section of a field effect transistor (MR), the series connection (1) being coupled between a first supply potential terminal (VDD) and a second supply potential terminal (VSS), wherein the voltage divider (2) comprises a first resistor (11) and a second resistor (12) being serially connected, a connection point (13) of the first resistor (11) and the second resistor (12) being connected to a gate connection (5) of the field effect transistor (MR); and
- a comparator (3), which at its input side is connected to a connection point (4) of the field effect transistor (MR) and the voltage divider (2), and on its output side is coupled to a detection output (6) of the voltage detection arrangement.

**2.** Voltage detection arrangement according to claim 1, wherein the first resistor (11) is connected to the controlled section of the field effect transistor (MR) and is dimensioned such that the field effect transistor (MR) is operated at or basically at a thermal compensation point regarding a temperature dependency of a drain-current and a gate-source-voltage of the field effect transistor (MR).

**3.** Voltage detection arrangement according to claim 1 or 2, wherein the second resistor (12) is dimensioned on the basis of a desired threshold level.

**4.** Voltage detection arrangement according to one of claims 1 to 3, wherein the voltage divider (2) comprises a resistor array of a plurality of serially connected resistors (41, 42, 43, 44, 45, 46), which form the first resistor (11) and the second resistor (12).

5. Voltage detection arrangement according to claim 4,
wherein a tap between two of the plurality of serially connected resistors (41, 42, 43, 44, 45, 46) forms the connection point (13) of the first resistor (11) and the second resistor (12).

6. Voltage detection arrangement according to claim 4 or 5, wherein the resistor array comprises a plurality of taps between each two of the plurality of serially connected resistors (41, 42, 43, 44, 45, 46), wherein one of the plurality of taps is fixed as the connection point (13) of the first resistor (11) and the second resistor (12) on the basis of a desired threshold level.

7. Voltage detection arrangement according to one of claims 1 to 6, wherein the first resistor (11) and the second resistor (12) are formed by a resistor strip (50), wherein a tap on the resistor strip (50) forms the connection point (13) of the first resistor (11) and the second resistor (12).

8. Voltage detection arrangement according to one of claims 1 to 7, wherein the series connection (1) is coupled to the first supply potential terminal (VDD) or to the second supply potential terminal (VSS) by means of a parallel connection of a third resistor (23) and a switch (33).

9. Voltage detection arrangement according to claim 8,
wherein the switch (33) is controlled on the basis of a signal at the detection output (6).

10. Voltage detection arrangement according to one of claims 1 to 9, wherein the series connection (1) is coupled to the first supply potential terminal (VDD) or to the second supply potential terminal (VSS) by means of one or more serially connected calibration resistors (21, 22), each of the calibration resistors (21, 22) being bridgeable or bridged by a calibration switch (31, 32).

11. Voltage detection arrangement according to claim 10,
wherein at least one calibration switch (31, 32) is implemented as a fuse, in particular a laser fuse or a polyfuse.

12. Voltage detection arrangement according to claim 10 or 11, wherein a conduction state of each of the calibration switches (31, 32) is programmed in a calibration process.

13. Voltage detection arrangement according to one of claims 1 to 12, wherein the comparator (3) is implemented as an inverter, in particular a CMOS-inverter (MP, MN).

14. Voltage detection arrangement according to one of claims 1 to 12, wherein the comparator (3) is implemented as a differential amplifier (60), a first input (61) of the differential amplifier (60) being connected to the connection point (4) of the field effect transistor (MR) and the voltage divider (2), and a second input (62) of the differential amplifier (60) being coupled to a reference voltage terminal (63).

Fig 1

VDD
1
5
S
MR
D
3
POR
4
6
Ra
11
13
Rb
12
2
VSS

Fig 2

VDD
POR
Rh
23
33
32
Rtn
22
VDD
31
20
Rt1
21
5
S
MR
MP
1
4
D
6
11
Ra
MN
13
12
Rb
2
3
VSS

Fig 3

VDD
5
MR
3
POR
4
6
41
1
42
11
Ra
43
2
44
13
45
Rb
12
46
VSS

Fig 4

VDD
5
MR
3
POR
1
4
6
50
Ra
11
13
2
12
Rb
VSS

Fig 5

VDD
5
MR
3
61
1
4
POR
63
62
60
6
Ra
11
13
2
Rb
12
VSS

Fig 6

VSS
5
MR
3
1
4
POR
6
Ra
11
13
2
Rb
12
VDD

Europäisches
Patentamt
European
Patent Office
Office européen
des brevets

# EUROPEAN SEARCH REPORT

Application Number
EP 11 17 5627

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 450 359 B1 (MEI TAWEN [US] ET AL) 11 November 2008 (2008-11-11) * column 1, line 33 - column 5, line 54; figure 1 * | 1-14 | INV. H03K17/22 |
| X<br>A | US 2006/145739 A1 (KIM DONG K [KR] KIM DONG KYUN [KR]) 6 July 2006 (2006-07-06) * figures 3,5 * | 1,4-12, 14<br>2,3,13 | |
| X<br>A | EP 0 479 202 A2 (NEC CORP [JP]) 8 April 1992 (1992-04-08) * figure 2 * | 1,4-12, 14<br>2,3,13 | |
| X<br>A | KR 2010 0018933 A (HYNIX SEMICONDUCTOR INC [KR]) 18 February 2010 (2010-02-18) * figures 1,3,4 * | 1,4-12, 14<br>2,3,13 | |

TECHNICAL FIELDS SEARCHED (IPC)

H03K

The present search report has been drawn up for all claims

| Place of search | Date of completion of the search | Examiner |
|---|---|---|
| The Hague | 8 December 2011 | Meulemans, Bart |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

1
EPO FORM 1503 03.82 (P04C01)

# ANNEX TO THE EUROPEAN SEARCH REPORT ON EUROPEAN PATENT APPLICATION NO.

EP 11 17 5627

This annex lists the patent family members relating to the patent documents cited in the above-mentioned European search report.
The members are as contained in the European Patent Office EDP file on
The European Patent Office is in no way liable for these particulars which are merely given for the purpose of information.

08-12-2011

| Patent document cited in search report | | Publication date | Patent family member(s) | | Publication date |
|---|---|---|---|---|---|
| US 7450359 | B1 | 11-11-2008 | NONE | | |
| US 2006145739 | A1 | 06-07-2006 | NONE | | |
| EP 0479202 | A2 | 08-04-1992 | DE | 69123538 D1 | 23-01-1997 |
| | | | DE | 69123538 T2 | 30-04-1997 |
| | | | EP | 0479202 A2 | 08-04-1992 |
| | | | JP | 2591305 B2 | 19-03-1997 |
| | | | JP | 4139914 A | 13-05-1992 |
| | | | US | 5136181 A | 04-08-1992 |
| KR 20100018933 | A | 18-02-2010 | NONE | | |

EPO FORM P0459

For more details about this annex : see Official Journal of the European Patent Office, No. 12/82